# EUROPEAN PATENT SPECIFICATION

(11) **EP 4 432 159 B1**
(45) Date of publication and mention of the grant of the patent: **29.04.2026**
(21) Application number: 22892810.7
(22) Date of filing: 09.11.2022
(51) Int. Cl.: G06K 19/077, H01L 21/60, H01L 23/12, H01L 23/00

(54) **IC MODULE AND METHOD FOR MANUFACTURING IC MODULE**
IC-MODUL UND VERFAHREN ZUR HERSTELLUNG DES IC-MODULS
MODULE DE CIRCUIT INTÉGRÉ ET PROCÉDÉ DE FABRICATION DE MODULE DE CIRCUIT INTÉGRÉ

(30) Priority: 09.11.2021 JP 2021182372
(43) Date of publication of application: 18.09.2024
(73) Proprietor: Toppan Holdings Inc., Tokyo 110-0016 (JP)
(72) Inventor: KANEKO, Shinji, Tokyo 110-0016 (JP); KATAOKA, Shin, Tokyo 110-0016 (JP)
(74) Representative: Hoffmann Eitle
(86) International application number: PCT/JP2022/041696
(87) International publication number: WO 2023/085312

(56) References cited:
- JP-A- 2011 227 568
- JP-A- H04 182 198

## Description

### [Technical Field]

The present invention relates to an IC module and a method for manufacturing an IC module.

### [Background Art]

There has been known an IC module, for example, as illustrated in PTLs 1 to 3, which is mounted with an IC chip having a contact communication function and a contactless communication function and which is attached to a card body and used as a dual IC card. The card body is capable of power supply and communication between the card body and the IC module by electromagnetic coupling (electromagnetic coupling, transformation coupling, or the like).

Electrically connecting such an IC module to a card body by electromagnetic coupling can suppress unstable electrical connection to the card body. This is because when the IC module and the card body are directly connected by a conductive connection member such as solder, the connection member may be broken when the dual IC card is bent.

An IC module to be mounted on an IC card includes a terminal for contact communication (contact terminal part) with an external contact machine formed on a front surface and a connection coil for contactless communication formed on a rear surface. In the IC module, the front surface of a substrate (contact-terminal substrate surface) is almost entirely covered with a metal surface from functional and design reasons. The metal surface is divided into several regions by a slit, and a terminal for contact communication, a signal line, and the like are formed. Further, the rear surface of the substrate (coil-formed substrate surface) is provided with a loop coil for contactless communication and an IC chip. Then, an electrode on the IC chip communicates with a metal plated pad formed on the rear surface (bonding side) of the substrate via a bonding wire (gold wire).

JP H04 182198 relates to the IC chip connected to a wiring electrode by a bonding wire is mounted on the rear of a substrate at the position corresponding to the section of the central part of an external terminal. The bonding wire and the IC chip are protected by a mold part covered with a resin. The mold part is set to the size received inside the longitudinal insulating grooves demarcating the ground terminal arranged to the center of the external terminal. Therefore, the bonding wire and the IC chip do not cross the longitudinal insulating grooves.

JP 2011 227568 refers to the IC module is configured so that a plurality of external terminals composed of respectively independent metal thin plates are formed on a surface of a non-conductive substrate through adhesive, apertures for exposing the rear faces of respective external terminals through the substrate are formed on a rear face of the substrate, and the IC chip is fixed on the rear face of the substrate through adhesive. When the IC chip is mounted so that a center part of the IC chip is superposed to a center part of the substrate, the pad electrode formed on the exposed surface of the IC chip is formed so as not to be located on the inside of a virtual band of 1 to 2 mm formed on the vertical/horizontal center part of the IC chip, and the bonding wire for connecting the pad electrode of the IC chip to the rear face of the external terminal which is exposed to the rear side of the substrate is connected so as not to cross the virtual band.

### [Citation List]

### [Patent Literature]

[PTL 1] WO 99/26195
[PTL 2] WO 98/15916
[PTL 3] WO 96/35190
[PTL 4] JP H04 182198 A
[PTL 5] JP 2011 227568 A

### [Summary of the Invention]

### [Technical Problem]

In the known IC module, the metal plated pad on the rear side of the substrate is sometimes disposed in a position that overlaps the slit (a region without a conductor pattern on the contact side), which is significantly deformed in response to application with external stress, on the front surface, when seen from the thickness direction of the substrate, or the bonding wire is sometimes disposed so as to step over the position. In this case, there is a possibility that external stress might cause large external force to act on the bonding wire, leading to disconnection of the wire.

The present invention has been made in view of the above-described problem and has as its object to provide an IC module which can suppress external force to act on a bonding wire provided to an IC module and can suppress disconnection of the bonding wire, and a method for manufacturing an IC module.

### [Solution to Problem]

This object is accomplished by the subject-matter of the independent claims. The dependent claims concern particular embodiments.

### [Advantageous Effects of the Invention]

According to the IC module and the method for manufacturing an IC module of the present invention, external force to act on the bonding wire provided to the IC module can be suppressed, and disconnection of the bonding wire can be suppressed.

### [Brief Description of the Drawings]

Fig. 1 is a plan view of an IC card according to a first embodiment of the present invention.
Fig. 2 is a plan view of a rear surface side of an IC module provided to the IC card illustrated in Fig. 1.
Fig. 3 is a cross-sectional view along line A-A illustrated in Fig. 2.
Fig. 4 is a plan view of a rear surface side of an IC module according to a second embodiment.

### [Description of the Embodiments]

An IC module and a method for manufacturing an IC module according to embodiments of the present invention will be described with reference to the drawings.

### (First Embodiment)

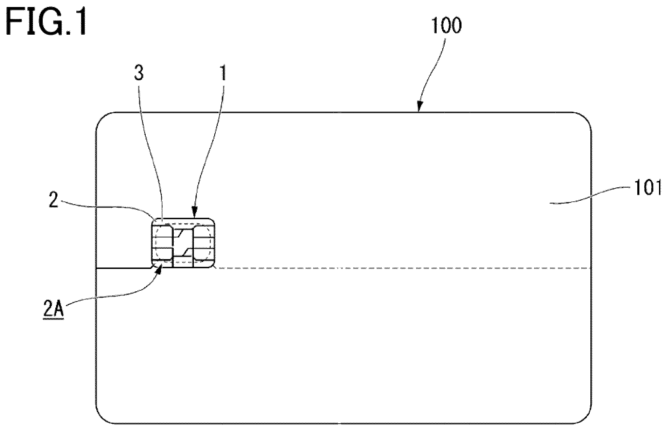

As illustrated in Fig. 1, an IC module 1 according to the present embodiment is used, for example, in an IC card 100 such as a credit card, a debit card, a cash card, or a card for access control. The IC module 1 is mounted on a card body 101 of the IC card 100.

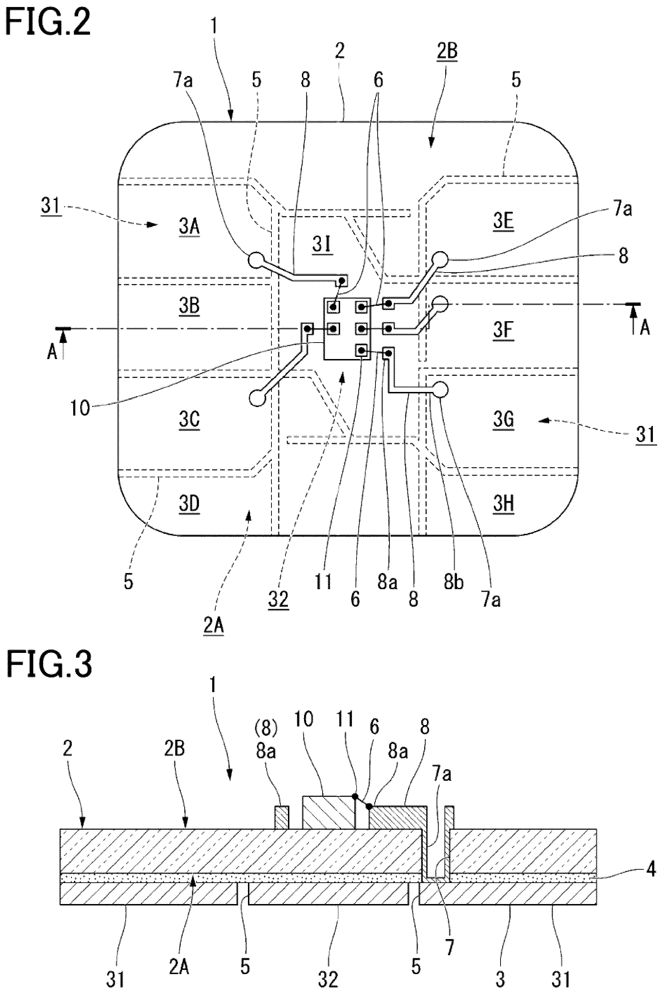

The IC module 1 is mounted with an IC chip 10 (see Fig. 2) constituting an integrated circuit having both a contact communication function and a contactless communication function. The IC module 1 has a sheet-like substrate 2 and a metal surface 3 (metal plate) that is one surface of the substrate 2 and covers almost the entirety of a front surface 2A (contact side).

A direction perpendicular to the front surface 2A (first surface ) and a rear surface 2B (second surface) opposite the front surface 2A of the substrate 2 is referred to as a thickness direction of the substrate 2, and a view seen to the thickness direction is referred to as a cross-sectional view.

As illustrated in Fig. 2and Fig. 3, as the IC chip 10, a chip of a known configuration having a contact communication function and a contactless communication function may be used.

The IC chip 10 is formed in a rectangular shape in plan view. The IC chip 10 is bonded to the substrate 2 by, for example, an adhesive agent for die attach. A plurality of connection terminals 11 to serve as electrodes is formed on an exposed outer surface of the IC chip 10.

Here, Fig. 2 illustrates the rear surface 2B of the substrate 2 in the IC module 1 and indicates the metal surface 3 and a later-described slit 5 on the front surface 2A by broken lines for facilitating explanation of the present embodiment.

The substrate 2 is formed in a rectangular shape in plan view. The thickness of the substrate 2 is, for example, 50 to 200 µm.

On the front surface 2A of the substrate 2, a terminal 31 (first terminal) for contact communication to be used for contact communication and a non-terminal metal surface 32 (second terminal) not to be used for contact communication are disposed. The rear surface 2B, which is the other surface opposite the front surface 2A of the substrate 2, forms a coil-formed substrate surface having an unillustrated loop coil (hereinafter, a connection coil) for contactless communication. That is, the rear surface 2B is disposed with a connection coil configured to be used for contactless communication and connected to an antenna on the card body 101 side via a bridge circuit on the front surface 2A.

A plurality of (here, eight) terminal regions (3A to 3H) is formed in the metal surface 3 by disposing a slit 5, and the above-describe terminal 31 for contact communication and, in a non-terminal region 3I which does not function as the terminal 31 for contact communication, the non-terminal metal surface 32 are formed. It is noted that a part of the non-terminal metal surface 32 may function as a signal line. The terminal 31 for contact communication (first terminal) and the non-terminal metal surface 32 (second terminal) may be linked directly or via a wiring pattern or the like.

The terminal 31 for contact communication is constituted by a metal plated layer formed on the front surface 2A of the substrate 2 through an adhesive material layer 4. The metal plate having the metal surface 3 is formed with a metal material having conductivity, such as nickel, palladium, gold, and copper. The adhesive material layer 4 is provided over the entire surface of the front surface 2A of the substrate 2.

The size and shape of the IC module 1 as well as the number and positions of terminals 31 for contact communication are defined according to a general standard of an IC module. In the present embodiment, four terminals 31 for contact communication are provided on each of both sides sandwiching the non-terminal metal surface 32 positioned in the left-light center on the paper of Fig. 2 in plan view. Further, the center portion on the front surface 2A of the substrate 2 is the non-terminal metal surface 32.

That is, on the front surface 2A of the substrate 2, the non-terminal metal surface 32 as the metal surface 3 is also formed in a portion other than the terminal surface (terminal surface for contact communication) used as the terminal 31 for contact communication.

Specifically, in the IC module 1, all or a part of the eight terminal regions 3A to 3H that are sectioned by the slit 5 and positioned on both the left and right sides in the metal surface 3 is used as the terminal 31 for contact communication. Each of the eight terminals 31 for contact communication forms a substantially rectangular shape in plan view. The non-terminal metal surface 32 is disposed in the center portion of the metal surface 3 sectioned by the slit 5. The non-terminal metal surface 32 is formed in the non-terminal region 3I having an optional planar shape. It is noted that a part of the non-terminal region 3I formed in the non-terminal metal surface 32 may function as a signal line. Further, the non-terminal metal surface 32 is configured to be the center region on the front surface 2A of the substrate 2 surrounded by the slit 5 but is not limited to be completely surrounded by the slit 5. The non-terminal metal surface 32 may be disposed in a location other than the center region on the front surface 2A.

In the IC module 1, a connection coil for contactless communication (not illustrated) formed in a spiral shape so as to surround the IC chip 10 illustrated in Fig. 2 is provided to the rear surface 2B, of the substrate 2, constituting a coil-formed substrate surface, and contactless mutual communication between the IC module 1 and another communication machine is enabled at least via this connection coil. It is noted that the form of the connection coil is similar to that of a connection coil in a known IC module. The connection coil is formed by patterning copper foil or aluminum foil by etching and has a thickness of, for example, 5 to 50 µm. The connection coil constitutes a contactless terminal part by electromagnetic coupling with a coupling coil (antenna) of the card body 101 illustrated in Fig. 1.

During contactless communication via the connection coil on the rear surface 2B of the substrate 2, an eddy current occurs on the terminal 31 for contact communication and the non-terminal metal surface 32. This eddy current occurs along a closed loop along the outer circumferential ends of the terminal regions 3A to 3H formed by the slit 5. An eddy current occurs in each of the six terminal regions 3A to 3H formed by the slit 5. As the closed loop is larger, a larger eddy current occurs.

The substrate 2 is formed mainly from an insulating substrate (insulating material) such as glass epoxy, polyimide (PI), or the like in a rectangular shape in plan view. The thickness of the substrate 2 is, for example, 50 to 200 µm. On the rear surface 2B of the substrate 2, an internal wiring having a bonding wire 6 is disposed. The internal wiring electrically couples the above-described terminal 31 for contact communication to an antenna of a metal plate.

In the central part on the rear surface 2B of the substrate 2 in plan view, the IC chip 10 is provided in a portion corresponding to a side opposite the non-terminal metal surface 32 on the front surface 2A. Around the IC chip 10, a plurality of metal plated pads 8 (connection pads) formed from metal plating is provided. Each of the plurality of metal plated pads 8 is joined to the connection terminal 11 of the IC chip 10 by the bonding wire 6.

In the substrate 2, a metal through hole 7 having a diameter of, for example, 0.4 to 1.0 mm and extending from the terminal 31 for contact communication on the front surface 2A of the substrate 2 to the rear surface 2B of the substrate 2 when seen from the thickness direction. It is noted that the shape of the through hole 7 illustrated in Fig. 2 is circular in plan view but is not limited to being circular. A via 7a constituted by a conductive body such as metal is provided to an inner surface of the through hole 7, and the via 7a is connected to the terminal 31 for contact communication. The via 7a is formed from, for example, a metal material having conductivity such as solder, silver paste, or copper plating. The via 7a of the present embodiment is provided to the inner surface of the through hole 7 and formed in a tubular shape, but the via 7a may be formed in a columnar shape that fills the inside of the through hole 7.

In the present embodiment, the via 7a is provided in each of five regions among the eight terminals 31 for contact communication. The via 7a is connected to the metal plated pad 8 to be connected to the IC chip 10 by the bonding wire 6.

The metal plated pad 8 is formed in a band shape in plan view, in such a manner as to extend from a position near the IC chip 10 to the via 7a which is disposed from the non-terminal metal surface 32 to each of the terminal regions 3A, 3C, 3E to 3G of the prescribed terminals 31 for contact communication across a position, on the rear surface 2B of the substrate 2, corresponding to the slit 5 on the front surface 2A (across a position overlapping the slit 5 when seen in the thickness direction). That is, a first connection end 8a as one end of the metal plated pad 8 is positioned near the IC chip 10, and a second connection end 8b as the other end is connected to the via 7a. The first connection end 8a is a bonding part to be bonded with the bonding wire 6.

It is noted that the first connection end 8a of the present embodiment is provided to an end, of the metal plated pad 8, closer to the IC chip 10 but is not limited thereto, and the first connection end 8a may be provided in a location, in the metal plated pad 8, positioned closer to the IC chip 10 than to the via 7a and overlapping the non-terminal metal surface 32 on the front surface 2A when seen in the thickness direction. The first connection end 8a is disposed in a position which does not overlap the slit 5 and overlaps the non-terminal metal surface 32 when seen from the thickness direction.

Examples of the material of the metal plated pad 8 include nickel, palladium, and gold (plating). The metal plated pad 8 may be formed from, for example, a conductive joining material such as solder or silver paste.

The bonding wire 6 is, for example, a wire material such as gold or copper having a diameter of 10 to 40 µm and connects the connection terminal 11 of the IC chip 10 and the first connection end 8a of the metal plated pad 8 to each other in such a manner as to step over therebetween. As the material of the bonding wire 6, for example, a gold line, a silver line, a copper line, or a line coated with other alloys or different types of metals may be adopted.

Further, the metal plated pad 8 on the rear surface 2B of the substrate 2 is positioned in a surrounding portion of the IC chip 10. The distance from the outer circumferential end of the IC chip 10 to the first connection end 8a of the metal plated pad 8 may be set to, for example, 100 µm or more and 1000 µm or less. The handling of the bonding wire 6 is optional, but the deformation amount of the bonding wire 6 caused by stress can be reduced by shortening the length of the bonding wire 6. It is noted that the outer circumferential end of the IC chip 10 is equivalent to the outer edge of the IC chip 10 when seen in the thickness direction.

Here, the bonding wire 6 extending toward one direction of the substrate 2 is set to be longer than the distance between the first connection end 8a of the metal plated pad 8 and the connection terminal 11 of the IC chip 10 in this one direction and is provided in a loosened state.

The length of the bonding wire 6 may be, for example, 100 µm or more and 1000 µm or less.

To the rear surface 2B of the substrate 2, unillustrated sealing resin is disposed, and the IC chip 10, the metal plated pad 8, the bonding wire 6, and the like are sealed in this sealing resin.

In the IC module 1 configured in this manner, a circuit is formed in the substrate 2 by bonding, for example, copper foil on both surfaces of a glass epoxy substrate and performing an etching treatment. Thereafter, nickel, gold, palladium, or the like is laminated by a plating treatment. The IC module 1 can be manufactured by providing the through hole 7 as necessary, forming the via 7a on the inner surface of the through hole 7 by copper plating or the like, and allowing conductor patterns on the front and rear surfaces of the substrate 2 to communicate with each other by the via 7a.

Next, the operation of the IC module 1 and the method for manufacturing the IC module 1 described above will be described in detail based on the drawings.

In the present embodiment, as illustrated in Fig. 2 and Fig. 3, the positions of the terminal regions 3A to 3H of the terminals 31 for contact communication constituting the conductor pattern in the substrate 2 are determined in accordance with the terminal position dimension on the IC card 100 (see Fig. 1) defined in the ISO standard. Therefore, the central region on the rear surface 2B of the substrate 2 on which the IC chip 10 is placed comes to be a region corresponding to a side opposite the non-terminal metal surface 32 (non-terminal region 3I) surrounded by the slit 5 where the conductor pattern of the metal surface 3 does not exist on the front surface 2A. In this case, disposing the metal plated pad 8 formed on the rear surface 2B of the substrate 2 to a position corresponding to a side opposite the central region (non-terminal metal surface 32) in the conductor pattern on the front surface 2A produces a configuration in which the bonding wire 6 linking between the connection terminal 11 of the IC chip 10 and the metal plated pad 8 on the rear surface 2B does not step over a portion, on the rear surface 2B, corresponding to a portion (slit 5) where the conductor on the front surface 2A side does not exist. That is, the bonding wire 6 is disposed in a position not overlapping the slit 5 when seen from the thickness direction.

Since a portion without the conductor on the front surface 2A of the substrate 2 is the slit 5 having a slit shape, deformation of this portion to external stress increases. Therefore, in the present embodiment, not disposing the bonding wire 6 in such a manner as to step over a portion, on the rear surface 2B, corresponding to a region (slit 5) without the conductor on the front surface 2A can reduce the external force to act on the bonding wire 6 caused by external stress and suppress a fracture risk.

Further, in the present embodiment, the position of the metal plated pad 8 on the rear surface 2B of the substrate 2 is the surrounding portion of the IC chip 10. For example, the distance from the outer circumferential end of the IC chip 10 to the first connection end 8a of the metal plated pad 8 is set to 100 µm or more and 1000 µm or less.

Since this can shorten the length of the bonding wire 6, the external force to act on the bonding wire 6 caused by external stress can be further reduced, and a fracture risk can be suppressed.

Further, in the present embodiment, the extending direction of the bonding wire 6 is provided in a direction along the lengthwise direction of the substrate 2, and the bonding wire 6 is set to be longer than the distance between the first connection end 8a of the metal plated pad 8 and the connection terminal 11 of the IC chip 10 and is provided in a loosened state.

According to this configuration, for example, when external stress, which causes the IC card to be bent along a direction intersecting the extending direction of the bonding wire 6 as the center axis of the bending in plan view, acts on the IC module 1, tensile force acts on the bonding wire 6 in the extending direction. In this case, since the bonding wire 6 is provided in a loosened state, fracture of the bonding wire 6 can be suppressed.

In this manner, in the present embodiment, external force to act on the bonding wire 6 provided to the IC module 1 can be suppressed, and disconnection of the bonding wire 6 can be suppressed.

### (Second Embodiment)

A conductor pattern applicable to an IC module for contact communication or for contactless communication is not necessarily the eight-terminal product of the first embodiment and may be any design (conductor pattern) on the contact side as the front surface 2A side of the substrate 2.

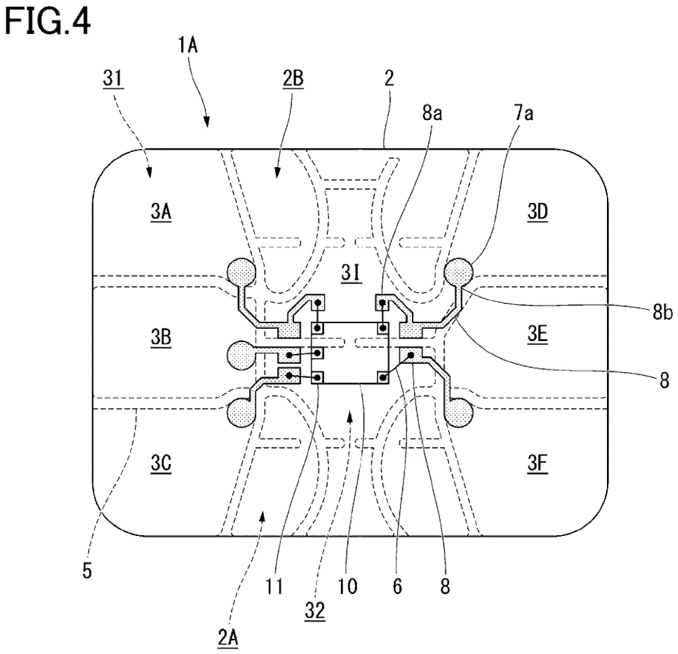

For example, Fig. 4 illustrates the rear surface 2B of the substrate 2 as a six-terminal product in an IC module 1A according to the present second embodiment.

As illustrated in Fig. 4, the IC module 1A according to the second embodiment also has a configuration substantially equivalent to that of the above-described IC module 1 and includes six terminal regions 3A to 3F of the terminals 31 for contact communication constituting a conductor pattern which are disposed in the substrate 2. The central region on the rear surface 2B of the substrate 2 on which the IC chip 10 is placed comes to be a region corresponding to a side opposite the non-terminal metal surface 32 (non-terminal region 3I) surrounded by the slit 5 where the conductor pattern of the metal surface 3 does not exist on the front surface 2A. In this case, disposing the metal plated pad 8 formed on the rear surface 2B of the substrate 2 to a position corresponding to the central region (non-terminal metal surface 32) in the conductor pattern on the front surface 2A produces a configuration in which the bonding wire 6 linking between the connection terminal 11 of the IC chip 10 and the metal plated pad 8 on the rear surface 2B does not step over a portion (slit 5) where the conductor on the front surface 2A side does not exist.

Subsequently, comparison results of the durability by a 3-wheel test, which was performed to a plastic card (IC card; hereinafter, may be merely referred to as a card) mounted with the IC module 1 as the eight-terminal product described in the first embodiment or the IC module 1A as the six-terminal product described in the second embodiment, will be described. In the following Table 1, the 3-wheel test results using a plastic card mounted with six-terminal or eight-terminal IC module are illustrated. The 3-wheel test is a durability test simulating a condition in which stress acts while a card is inserted into an ATM. Specifically, when a card is inserted into an ATM, the card is held between one transfer wheel disposed on one surface and two transfer wheels disposed on the other surface, transferred by these wheels rotating, and subjected to stress by the wheels during this transfer, causing external force to be applied to the contact terminal part. When external force is repeatedly applied to the contact terminal part, for example, the bonding wire in the sealing resin may be disconnected, and communication may be disabled. For the transfer wheels, an external force of 8 N is defined as a criterion in the ISO, and external forces of 8 N, 10 N (recommended), and 12 N (recommended) are defined as a criterion in the card quality management (CQM) standard. In the following Table 1, "X/Y Passed" indicates that X test pieces out of Y test pieces have passed.

**[Table 1]**

| Test condition (50 times for each of front and rear) | Six-terminal product | | Eight-terminal product | |
|---|---|---|---|---|
| | Known configuration | Present configuration | Known configuration | Present configuration |
| 8 N (ISO, CQM) | 7/10 Passed | 10/10 Passed | 12/15 Passed | 15/15 Passed |
| 10 N (CQM) | 8/10 Passed | 10/10 Passed | 11/14 Passed | 15/15 Passed |
| 12 N (CQM) | 3/10 Passed | 9/10 Passed | 5/15 Passed | 15/15 Passed |

In a case of the known configuration, the result of the 3-wheel test for each of the six-terminal product and the eight-terminal product satisfied neither the ISO nor CQM standard. On the other hand, as found from the result of the 3-wheel test using the IC module having the configuration of the present application, the six-terminal product and the eight-terminal product both improved in durability. In the known configuration, the connection end of the connection pad (i.e., the metal plated pad 8) is positioned in a portion, on the rear surface, corresponding to the slit on the front surface, so that deformation of the connection pad to external stress is large, causing an increase in external force to act on the 2nd bonding part (the bonding portion of the bonding wire on the connection pad). It is considered that this caused the disconnection of the bonding wire and the occurrence of communication failure.

For the IC module having the known configuration and the IC module having the configuration of the present application, the lengths of the bonding wires are compared, and the result is illustrated in the following Table 2. It is understood that since the connection pad in the IC module having the configuration of the present application is located near the IC chip as compared to the known configuration, the average length of the bonding wire having the configuration of the present application is less than half that of the known configuration. Further, in the IC module having the present configuration, unlike in the product having the known configuration, the bonding pad (2nd bonding part) is not disposed in a position, on the rear surface, stepping over a portion corresponding to the slit provided between the plurality of terminals on the front surface, and therefore, external force to act on the bonding part in response to application with external stress is reduced.

**[Table 2]**

| | | Eight-terminal module/mm | | Six-terminal module/mm | |
|---|---|---|---|---|---|
| | | Known configuration | Present configuration | Known configuration | Present configuration |
| Type of terminal | GND | 1.0 | 0.7 | 2.3 | 0.6 |
| | I/O | 1.0 | 0.6 | 1.7 | 0.6 |
| | VCC | 1.0 | 0.6 | 2.3 | 0.7 |
| | RST | 1.1 | 0.7 | 1.6 | 0.7 |
| | CLK | 1.3 | 0.8 | 1.8 | 0.5 |
| | ACO | 1.4 | 0.5 | 0.9 | 0.8 |
| | AC1 | 1.2 | 0.5 | 1.0 | 0.7 |
| Maximum | | 1.4 | 0.8 | 2.3 | 0.8 |
| Minimum | | 1.0 | 0.5 | 0.9 | 0.5 |
| Average | | 1.2 | 0.6 | 1.7 | 0.7 |

As described above, the IC modules 1 and 1A of the above-described embodiments each includes: a substrate 2 that has a front surface 2A (first surface) and a rear surface 2B (second surface) opposite the front surface 2A and has a metal surface 3 at least on the front surface 2A; and an IC chip 10 that has both a contact communication function and a contactless communication function and is mounted on the rear surface 2B of the substrate 2, in which a plurality of terminals constituted by the metal surface 3 is formed on the front surface 2A of the substrate 2, the plurality of terminals containing a terminal 31 for contact communication (first terminal) used for contact communication and a non-terminal metal surface 32 (second terminal) other than the terminal 31 for contact communication, and the substrate 2 includes a via 7a that is formed on an inner surface of a through hole 7 penetrating from the front surface 2A to the rear surface 2B and is connected to the terminal 31 for contact communication, a metal plated pad 8 (connection pad), made of metal, extending from the via 7a to a portion, on the rear surface 2B, positioned opposite the non-terminal metal surface 32 overlapping the IC chip 10 when seen from a thickness direction of the substrate 2, and a bonding wire 6 that connects between a first connection end 8a (connection end), of the metal plated pad 8, positioned closer to the IC chip 10 than to the via 7a and a connection terminal 11 of the IC chip 10.

In the IC modules 1 and 1A of the embodiments, the substrate 2 has a slit 5 between the plurality of terminals such as the terminal 31 for contact communication and the non-terminal metal surface 32, and the bonding wire 6 is disposed in a position not overlapping the slit 5 when seen in the thickness direction.

In the IC modules 1 and 1A of the above-described embodiments, the metal plated pad 8 (connection pad) is positioned in the surrounding portion of the IC chip 10 on the rear surface 2B (second surface) of the substrate 2.

In the IC modules 1 and 1A of the above-described embodiments, the distance from the outer circumferential end of the IC chip 10 to the first connection end 8a (connection end) of the metal plated pad 8 (connection pad) is, for example, 1000 µm or less.

In the IC modules 1 and 1A of the above-described embodiments, the length of the bonding wire is, for example, 1000 µm or less.

In the IC modules 1 and 1A of the above-described embodiments, the bonding wire 6 extending toward one direction of the substrate 2 is set to be longer than the distance between the first connection end 8a (connection end) of the metal plated pad 8 (connection pad) and the connection terminal 11 of the IC chip 10 in the one direction and is provided in a loosened state.

The method for manufacturing an IC module including a substrate 2 that has a front surface 2A (first surface) and a rear surface 2B (second surface) opposite the front surface 2A and has a metal surface 3 at least on the front surface 2A and an IC chip 10 that has both a contact communication function and a contactless communication function and is mounted on the rear surface 2B of the substrate 2, according to the above-described embodiment, includes: forming, on the front surface 2A of the substrate 2, a plurality of terminals that is constituted by the metal surface 3 and contains a terminal 31 for contact communication (first terminal) used for contact communication and a non-terminal metal surface 32 (second terminal) other than the terminal 31 for contact communication; providing, on an inner surface of a through hole 7 penetrating from the front surface 2A to the rear surface 2B, a via 7a connected to the terminal 31 for contact communication; providing a metal plated pad 8 (connection pad) extending from the via 7a to a portion, on the rear surface 2B, positioned opposite the non-terminal metal surface 32 overlapping the IC chip 10 when seen from the thickness direction of the substrate 2; and connecting between the first connection end 8a (connection end), of the metal plated pad 8, positioned closer to the IC chip 10 than to the via 7a and the connection terminal 11 of the IC chip 10 by a bonding wire 6.

The embodiments of the present invention have been described above in detail with reference to the drawings, but specific configurations are not limited to the embodiments and also encompass modifications, combinations, and the like of the configurations within the scope of the present invention.

For example, the position of the metal plated pad 8 on the rear surface 2B of the substrate 2 is configured to be the surrounding portion of the IC chip 10 in the present embodiment, but it is enough for the first connection end 8a of the metal plated pad 8 to be in a portion overlapping the non-terminal metal surface 32 (non-terminal region 3I) on the front surface 2A, and the metal plated pad 8 may not be provided in the surrounding portion of the IC chip 10.

Further, an example in which the distance from the end of the IC chip 10 to the first connection end 8a of the metal plated pad 8 is 100 µm or more and 1000 µm or less has been illustrated, but the distance may be outside this range.

An example in which the length of the bonding wire 6 is 100 µm or more and 1000 µm or less has been illustrated, but the length may be outside this range.

Furthermore, the present embodiment has a configuration in which the extending direction of the bonding wire 6 is provided in a direction along the lengthwise direction of the substrate 2, and the bonding wire 6 is set to be longer than the distance between the first connection end 8a of the metal plated pad 8 and the connection terminal 11 of the IC chip 10 and is provided in a loosened state. However, the configuration is not limited to disposing the bonding wire 6 in a loosened state in this manner, and the bonding wire 6 may have the same length as the distance between the first connection end 8a of the metal plated pad 8 and the connection terminal 11 of the IC chip 10.

The non-terminal metal surface 32 of the present embodiment is not used for contact communication but is not limited thereto, and the non-terminal metal surface 32 may be, for example, a terminal used for contact communication in an operation test of the IC module.

### [Reference Signs List]

100: IC card
1, 1A: IC module
2: Substrate
2A: Front surface
2B: Rear surface
3: Metal surface
3A to 3H: Terminal region
3I: Non-terminal region
4: Adhesive material layer
5: Slit
6: Bonding wire
7: Through hole
7A: Via
8: Metal plated pad (connection pad)
8A: First connection end
10: IC chip
11: Connection terminal
31: Terminal for contact communication (first terminal)
32: Non-terminal metal surface (second terminal)

## Claims

1. An IC module (1, 1A) comprising: a substrate (2) that has a first surface (2A) and a second surface (2B) opposite the first surface and has a metal surface (3) at least on the first surface; and an IC chip (10) that has both a contact communication function and a contactless communication function and is mounted on the second surface (2B) of the substrate (2), wherein
a plurality of terminals constituted by the metal surface is formed on the first surface of the substrate (2), the plurality of terminals containing a first terminal (31) used for contact communication and a second terminal (32) other than the first terminal (31),
the second terminal (32) is not used for contact communication,
**characterised in that**
the substrate (2) includes
a via (7A) that is formed on an inner surface of a through hole (7) penetrating from the first surface (2A) to the second surface (2B) and is connected to the first terminal (31),
a metal connection pad (8) extending from the via (7A) to a connection end (8a) of the connection pad (8), on the second surface (2B), the connection end (8a) being positioned opposite the second terminal (32), the second terminal (32) overlapping the IC chip (10) when seen from a thickness direction of the substrate (2), the connection end (8a) overlapping the second terminal (32) when seen from the thickness direction, and
a bonding wire (6) that connects between the connection end (8a), of the connection pad (8), positioned closer to the IC chip (10) than to the via (7A) and a connection terminal (11) of the IC chip (10).

2. The IC module (1, 1A) according to claim 1, wherein
the substrate (2) has a slit (5) between the plurality of terminals, and
the bonding wire (6) is disposed in a position that does not overlap the slit (5) when seen from the thickness direction.

3. The IC module (1, 1A) according to claim 1, wherein the connection pad is positioned in a surrounding portion of the IC chip (10) on the second surface of the substrate (2).

4. The IC module (1, 1A) according to claim 3, wherein a distance from an outer circumferential end of the IC chip (10) to the connection end of the connection pad (8) is 1000 µm or less.

5. The IC module (1, 1A) according to claim 4, wherein a length of the bonding wire (6) is 1000 µm or less.

6. The IC module (1, 1A) according to any one of claims 1 to 5, wherein the bonding wire (6) extending toward one direction of the substrate (2) is set to be longer than a distance between the connection end (8a) of the connection pad (8) and the connection terminal (11) of the IC chip (10) in the one direction and is provided in a loosened state.

7. A method for manufacturing an IC module (1, 1A) including a substrate (2) that has a first surface and a second surface opposite the first surface and has a metal surface at lease on the first surface and an IC chip (10) that has both a contact communication function and a contactless communication function and is mounted on the second surface of the substrate (2), comprising:
forming, on the first surface of the substrate (2), a plurality of terminals that is constituted by the metal surface and contains a first terminal (31) used for connection communication and a second terminal (32) other than the first terminal (31), wherein the second terminal (32) is not used for contact communication,;
providing, on an inner surface of a through hole (7) penetrating from the first surface to the second surface, a via (7A) connected to the first terminal (31);
providing a metal connection pad (8) extending from the via (7A) to a connection end (8a) of the connection pad (8), on the second surface, the connection end (8a) being positioned opposite the second terminal (32), the second terminal (32) overlapping the IC chip (10) when seen from a thickness direction of the substrate (2), the connection end (8a) overlapping the second terminal (32) when seen from the thickness direction; and
connecting between a connection end, of the connection pad, positioned closer to the IC chip (10) than to the via (7A) and a connection terminal (11) of the IC chip (10) by a bonding wire (6).

## Patentansprüche

1. IC-Modul (1, 1A) umfassend: ein Substrat (2), das eine erste Oberfläche (2A) und eine der ersten Oberfläche gegenüberliegende zweite Oberfläche (2B) aufweist und eine Metalloberfläche (3) mindestens auf der ersten Oberfläche aufweist; und einen IC-Chip (10), der sowohl eine Kontaktkommunikationsfunktion als auch eine berührungslose Kommunikationsfunktion aufweist und auf der zweiten Oberfläche (2B) des Substrats (2) montiert ist, wobei
eine Vielzahl von Anschlüssen, die durch die Metalloberfläche gebildet sind, auf der ersten Oberfläche des Substrats (2) gebildet ist, wobei die Vielzahl von Anschlüssen einen ersten Anschluss (31), der für Kontaktkommunikation verwendet wird, und einen zweiten Anschluss (32) außer dem ersten Anschluss (31) enthält,
der zweite Anschluss (32) nicht für Kontaktkommunikation verwendet wird, **dadurch gekennzeichnet, dass**
das Substrat (2) Folgendes einschließt
eine Durchkontaktierung (7A), die auf einer Innenfläche eines Durchgangslochs (7) gebildet ist, das von der ersten Oberfläche (2A) zur zweiten Oberfläche (2B) durchdringt, und die mit dem ersten Anschluss (31) verbunden ist,
ein metallisches Verbindungspad (8), das sich von der Durchkontaktierung (7A) zu einem Verbindungsende (8a) des Verbindungspads (8) auf der zweiten Oberfläche (2B) erstreckt, wobei das Verbindungsende (8a) dem zweiten Anschluss (32) gegenüberliegend positioniert ist, wobei der zweite Anschluss (32) den IC-Chip (10) überlappt, wenn in Dickenrichtung des Substrats (2) betrachtet, wobei das Verbindungsende (8a) den zweiten Anschluss (32) überlappt, wenn in der Dickenrichtung betrachtet, und
einen Bonddraht (6), der das Verbindungsende (8a) des Verbindungspads (8), das näher zum IC-Chip (10) als zur Durchkontaktierung (7A) positioniert ist, und einen Verbindungsanschluss (11) des IC-Chips (10) verbindet.

2. IC-Modul (1, 1A) nach Anspruch 1, wobei
das Substrat (2) einen Schlitz (5) zwischen der Vielzahl von Anschlüssen aufweist, und
der Bonddraht (6) in einer Position angeordnet ist, die den Schlitz (5) nicht überlappt, wenn in der Dickenrichtung betrachtet.

3. IC-Modul (1, 1A) nach Anspruch 1, wobei das Verbindungspad in einem umgebenden Bereich des IC-Chips (10) auf der zweiten Oberfläche des Substrats (2) positioniert ist.

4. IC-Modul (1, 1A) nach Anspruch 3, wobei ein Abstand von einem äußeren Umfangsrand des IC-Chips (10) bis zu dem Verbindungsende des Verbindungspads (8) 1000 µm oder weniger beträgt.

5. IC-Modul (1, 1A) nach Anspruch 4, wobei eine Länge des Bonddrahts (6) 1000 µm oder weniger beträgt.

6. IC-Modul (1, 1A) nach einem der Ansprüche 1 bis 5, wobei der Bonddraht (6), der sich in eine Richtung des Substrats (2) erstreckt, so eingestellt ist, dass er in der einen Richtung länger ist als ein Abstand zwischen dem Verbindungsende (8a) des Verbindungspads (8) und dem Verbindungsanschluss (11) des IC-Chips (10) und in einem gelockerten Zustand bereitgestellt ist.

7. Verfahren zur Herstellung eines IC-Moduls (1, 1A) einschließlich eines Substrats (2), das eine erste Oberfläche und eine der ersten Oberfläche gegenüberliegende zweite Oberfläche aufweist und eine Metalloberfläche mindestens auf der ersten Oberfläche aufweist, und eines IC-Chips (10), der sowohl eine Kontaktkommunikationsfunktion als auch eine berührungslose Kommunikationsfunktion aufweist und auf der zweiten Oberfläche des Substrats (2) montiert ist, umfassend:
Bilden, auf der ersten Oberfläche des Substrats (2), einer Vielzahl von Anschlüssen, die durch die Metalloberfläche gebildet ist und einen ersten Anschluss (31), der für Kontaktkommunikation verwendet wird, und einen zweiten Anschluss (32) außer dem ersten Anschluss (31) enthält, wobei der zweite Anschluss (32) nicht für Kontaktkommunikation verwendet wird;
Bereitstellen, auf einer Innenfläche eines Durchgangslochs (7), das von der ersten Oberfläche zur zweiten Oberfläche durchdringt, einer Durchkontaktierung (7A), die mit dem ersten Anschluss (31) verbunden ist;
Bereitstellen eines metallischen Verbindungspads (8), das sich von der Durchkontaktierung (7A) zu einem Verbindungsende (8a) des Verbindungspads (8), auf der zweiten Oberfläche, erstreckt, wobei das Verbindungsende (8a) dem zweiten Anschluss (32) gegenüberliegend positioniert ist, wobei der zweite Anschluss (32) den IC-Chip (10) überlappt, wenn in Dickenrichtung des Substrats (2) betrachtet, wobei das Verbindungsende (8a) den zweiten Anschluss (32) überlappt, wenn in der Dickenrichtung betrachtet; und
Verbinden eines Verbindungsendes, des Verbindungspads, das näher zum IC-Chip (10) als zur Durchkontaktierung (7A) positioniert ist, und eines Verbindungsanschlusses (11) des IC-Chips (10) mittels eines Bonddrahts (6).

## Revendications

1. Module de circuit intégré (1, 1A) comprenant : un substrat (2) qui présente une première surface (2A) et une seconde surface (2B) opposée à la première surface et présente une surface métallique (3) au moins sur la première surface ; et une puce de circuit intégré (10) qui présente à la fois une fonction de communication par contact et une fonction de communication sans contact et est montée sur la seconde surface (2B) du substrat (2), dans lequel
une pluralité de bornes constituée par la surface métallique est formée sur la première surface du substrat (2), la pluralité de bornes contenant une première borne (31) utilisée pour la communication par contact et une seconde borne (32) distincte de la première borne (31),
la seconde borne (32) n'est pas utilisée pour la communication par contact, **caractérisé en ce que**
le substrat (2) inclut
un trou d'interconnexion (7A) qui est formé sur une surface interne d'un trou traversant (7) pénétrant de la première surface (2A) à la seconde surface (2B) et est connecté à la première borne (31),
un plot de connexion métallique (8) s'étendant du trou d'interconnexion (7A) vers une extrémité de connexion (8a) du plot de connexion (8), sur la seconde surface (2B), l'extrémité de connexion (8a) étant positionnée de manière opposée à la seconde borne (32), la seconde borne (32) chevauchant la puce de circuit intégré (10) lorsqu'on la regarde dans la direction d'épaisseur du substrat (2), l'extrémité de connexion (8a) chevauchant la seconde borne (32) lorsqu'on la regarde dans la direction d'épaisseur, et
un fil de liaison (6) connectant l'extrémité de connexion (8a), du plot de connexion (8), positionnée plus près de la puce de circuit intégré (10) que du trou d'interconnexion (7A) et une borne de connexion (11) de la puce de circuit intégré (10).

2. Module de circuit intégré (1, 1A) selon la revendication 1, dans lequel
le substrat (2) présente une fente (5) entre la pluralité de bornes, et
le fil de liaison (6) est disposé dans une position qui ne chevauche pas la fente (5) lorsqu'on le regarde dans la direction d'épaisseur.

3. Module de circuit intégré (1, 1A) selon la revendication 1, dans lequel le plot de connexion est positionné dans une portion entourant la puce de circuit intégré (10) sur la seconde surface du substrat (2).

4. Module de circuit intégré (1, 1A) selon la revendication 3, dans lequel une distance depuis une extrémité périphérique externe de la puce de circuit intégré (10) jusqu'à l'extrémité de connexion du plot de connexion (8) est inférieure ou égale à 1 000 µm.

5. Module de circuit intégré (1, 1A) selon la revendication 4, dans lequel une longueur du fil de liaison (6) est inférieure ou égale à 1 000 µm.

6. Module de circuit intégré (1, 1A) selon l'une quelconque des revendications 1 à 5, dans lequel le fil de liaison (6) s'étendant vers une direction du substrat (2) est réglé de manière à être plus long qu'une distance entre l'extrémité de connexion (8a) du plot de connexion (8) et la borne de connexion (11) de la puce de circuit intégré (10) dans ladite direction et est fourni dans un état desserré.

7. Procédé destiné à fabriquer un module de circuit intégré (1, 1A) incluant un substrat (2) qui présente une première surface et une seconde surface opposée à la première surface et présente une surface métallique au moins sur la première surface et une puce de circuit intégré (10) qui présente à la fois une fonction de communication par contact et une fonction de communication sans contact et est montée sur la seconde surface du substrat (2), comprenant :
former, sur la première surface du substrat (2), une pluralité de bornes qui est constituée par la surface métallique et contient une première borne (31) utilisée pour la communication par contact et une seconde borne (32) distincte de la première borne (31), dans lequel la seconde borne (32) n'est pas utilisée pour la communication par contact ;
fournir, sur une surface interne d'un trou traversant (7) pénétrant de la première surface à la seconde surface, un trou d'interconnexion (7A) connecté à la première borne (31) ;
fournir un plot de connexion métallique (8) s'étendant du trou d'interconnexion (7A) vers une extrémité de connexion (8a) du plot de connexion (8), sur la seconde surface, l'extrémité de connexion (8a) étant positionnée de manière opposée à la seconde borne (32), la seconde borne (32) chevauchant la puce de circuit intégré (10) lorsqu'on la regarde dans la direction d'épaisseur du substrat (2), l'extrémité de connexion (8a) chevauchant la seconde borne (32) lorsqu'on la regarde dans la direction d'épaisseur ; et
connecter entre une extrémité de connexion, du plot de connexion, positionnée plus près de la puce de circuit intégré (10) que du trou d'interconnexion (7A) et une borne de connexion (11) de la puce de circuit intégré (10) par un fil de liaison (6).
